# EUROPEAN PATENT APPLICATION

(11) **EP 2 560 171 A2**
(43) Date of publication of application: **20.02.2013**
(21) Application number: 12179909.2
(22) Date of filing: 09.08.2012
(51) Int. Cl.: G11C 13/00, G11C 11/56

(54) **Nonvolatile resistive memory elements and memory devices including the same**

(30) Priority: 19.08.2011 KR 20110083056
(71) Applicant: Samsung Electronics Co., Ltd., Suwon-si, Gyeonggi-do, 443-742 (KR)
(72) Inventor: Lee, Seung-ryul, 449-712 Gyeonggi-do (KR); Kim, Young-bae, 449-712 Gyeonggi-do (KR); Kim, Chang-jung, 449-712 Gyeonggi-do (KR); Lee, Myoung-jae, 449-712 Gyeonggi-do (KR); Hur, Ji-hyun, 449-712 Gyeonggi-do (KR); Lee, Dong-soo, 449-712 Gyeonggi-do (KR); Chang, Man, 449-712 Gyeonggi-do (KR); Lee, Chang-bum, 449-712 Gyeonggi-do (KR); Kim, Kyung-min, 449-712 Gyeonggi-do (KR)
(74) Representative: Greene, Simon Kenneth

(57) **Abstract**

Nonvolatile memory elements and memory devices including the nonvolatile memory elements. A nonvolatile memory element may include a memory layer between two electrodes, and the memory layer may have a multi-layer structure. The memory layer may include a base layer and an ionic species exchange layer and may have a resistance change characteristic due to movement of ionic species between the base layer and the ionic species exchange layer. The ionic species exchange layer may have a multi-layer structure including at least two layers. The nonvolatile memory element may have a multi-bit memory characteristic due to the ionic species exchange layer having the multi-layer structure. The base layer may be an oxygen supplying layer, and the ionic species exchange layer may be an oxygen exchange layer.

## Description

### BACKGROUND OF THE INVENTION

Example embodiments relate to nonvolatile memory elements and memory devices including the same.

Examples of nonvolatile memories include resistive random access memory (RRAM), magnetic random access memory (MRAM), ferroelectric random access memory (FRAM), phase-change random access memory (PRAM), and the like. A RRAM is a resistive memory device that stores data based on resistance change characteristics of a material. In an RRAM, the resistance of a resistance-change material is changed from a high-resistance state to a low-resistance state (also called as "ON state") when a voltage applied to the resistance-change material is greater than or equal to a set voltage. The resistance of the resistance-change material is switched back to the high-resistance state (also called as "OFF state") when a voltage applied to the resistance-change material is greater than or equal to a reset voltage.

Generally, a resistive memory device includes a storage node and a switching device. The storage node has a resistance-change material layer. The switching device is electrically connected to the storage node and controls access of a signal to the storage node.

### SUMMARY OF THE INVENTION

Example embodiments may provide nonvolatile memory elements using resistance change characteristics. Example embodiments may provide nonvolatile memory elements with multi-bit memory characteristics. Example embodiments may provide nonvolatile memory elements with an improved and/or decreased operation voltage. Example embodiments may provide memory devices including the nonvolatile memory elements.

According to example embodiments, a nonvolatile memory element includes a first electrode, a second electrode which is spaced apart from the first electrode, and a memory layer disposed between the first electrode and the second electrode. The memory layer includes a base layer and an ionic species exchange layer and has a resistance change characteristic due to movement of ionic species between the base layer and the ionic species exchange layer, and the ionic species exchange layer has a multi-layer structure comprising at least two layers.

The base layer may be an oxygen supplying layer, and the ionic species exchange layer may be an oxygen exchange layer. The nonvolatile memory element may have a multi-bit memory characteristic due to the ionic species exchange layer having the multi-layer structure. The ionic species exchange layer may include a first exchange layer and a second exchange layer. The first exchange layer may be disposed between the base layer and the second electrode, and the second exchange layer may be disposed between the first exchange layer and the second electrode.

The first exchange layer and the second exchange layer may be formed of different metal oxides. The first exchange layer may be formed of a first metal oxide, and the second exchange layer may be formed of a second metal oxide of which a metal composition is different from that of the first metal oxide. A resistivity of the second exchange layer may be higher than that of the first exchange layer. An oxygen affinity of the second exchange layer may be larger than or equal to that of the first exchange layer. A conduction band offset of the second exchange layer to the base layer may be larger than that of the first exchange layer to the base layer.

A thickness of the second exchange layer may be thinner than or equal to that of the first exchange layer. The first exchange layer may include at least one selected from the group consisting of tantalum (Ta) oxide, zirconium (Zr) oxide, yttrium (Y) oxide, yttria-stabilized zirconia (YSZ), titanium (Ti) oxide, hafnium (Hf) oxide, manganese (Mn) oxide, magnesium (Mg) oxide, and combinations thereof. The second exchange layer may include at least one selected from the group consisting of Ta oxide, Zr oxide, Y oxide, YSZ, Ti oxide, Hf oxide, Mn oxide, Mg oxide, and combinations thereof. The base layer may include metal oxide. Oxygen concentration of the base layer may be lower than that of the ionic species exchange layer.

The metal oxide of the base layer may include at least one selected from the group consisting of Ta oxide, Zr oxide, Y oxide, YSZ, Ti oxide, Hf oxide, Mn oxide, Mg oxide, and combinations thereof. The metal oxide of the base layer may include TaOx (here, 0<x<2.5). The nonvolatile memory element may further include a buffer layer between the first electrode and the memory layer. The buffer layer may include a material for increasing the height of a potential barrier between the first electrode and the memory layer.

According to other example embodiments, a memory device includes the aforementioned nonvolatile memory element. The memory device may further include a switching element connected to the nonvolatile memory element.

According to still other example embodiments, a memory device includes a plurality of first wires arranged in parallel with each other, a plurality of second wires arranged in parallel with each other and crossing the first wires to form a plurality of cross-points, and a plurality of memory cells, each of the memory cells being arranged at one of the cross-points. Each of the memory cells includes a memory layer, the memory layer including a base layer and an ionic species exchange layer and has a resistance change characteristic due to movement of an ionic species between the base layer and the ionic species exchange layer, and the ionic species exchange layer has a multi-layer structure comprising at least two layers.

The base layer may be an oxygen supplying layer, and the ionic species exchange layer may be an oxygen exchange layer. The memory layer may have a multi-bit memory characteristic due to the ionic species exchange layer having the multi-layer structure. Each of the memory cells may further include a switching element disposed between the memory layer and the second wire, and an intermediate electrode disposed between the memory layer and the switching element. The ionic species exchange layer may include a first exchange layer and a second exchange layer, and the first exchange layer may be disposed between the base layer and the second exchange layer. The first exchange layer and the second exchange layer may be formed of different metal oxides.

A resistivity of the second exchange layer may be higher than that of the first exchange layer. An oxygen affinity of the second exchange layer may be larger than or equal to that of the first exchange layer. A conduction band offset of the second exchange layer to the base layer may be larger than that of the first exchange layer to the base layer. The first exchange layer may include at least one selected from the group consisting of tantalum (Ta) oxide, zirconium (Zr) oxide, yttrium (Y) oxide, yttria-stabilized zirconia (YSZ), titanium (Ti) oxide, hafnium (Hf) oxide, manganese (Mn) oxide, magnesium (Mg) oxide, and combinations thereof. The second exchange layer may include at least one selected from the group consisting of Ta oxide, Zr oxide, Y oxide, YSZ, Ti oxide, Hf oxide, Mn oxide, Mg oxide, and combinations thereof.

The base layer may include metal oxide. The metal oxide of the base layer may include at least one selected from the group consisting of Ta oxide, Zr oxide, Y oxide, YSZ, Ti oxide, Hf oxide, Mn oxide, Mg oxide, and combinations thereof. The metal oxide of the base layer may include TaOx (here, 0<x<2.5). Each of the memory cells may further include a buffer layer between the first wire and the memory layer. The plurality of memory cells may be first memory cells, and the memory device may further include a plurality of third wires arranged on the second wires so as to cross the second wires and form a plurality of second cross-points, and a plurality of second memory cells, each of the second memory cells being arranged at one of the second cross-points. The second memory cells each may have a reverse structure of the first memory cell or the same structures as the first memory cell.

According to at least one example embodiment, a nonvolatile memory element including a first electrode, a second electrode, and a resistance change memory layer between the first and second electrodes, the memory layer including, a base layer, and an ionic species exchange layer including at least two layers.

According to at least one example embodiment, a memory device includes a plurality of first wires, a plurality of second wires crossing the first wires, and a plurality of first memory cells at a plurality of first cross-points between the first and second wires, each of the first memory cells including a resistance change memory layer, each of the memory layers including a base layer, and an ionic species exchange layer including at least two layers.

### BRIEF DESCRIPTION OF THE DRAWINGS

Example embodiments will be more clearly understood from the following brief description taken in conjunction with the accompanying drawings. FIGS. 1-14 represent non-limiting, example embodiments as described herein.
FIG. 1 is a cross-sectional diagram illustrating nonvolatile memory elements according to example embodiments;
FIGS. 2A and 2B are cross-sectional diagrams illustrating operation mechanisms of a nonvolatile memory element according to at least one example embodiment;
FIG. 3 is a cross-sectional diagram illustrating memory elements according to other example embodiments;
FIG. 4 is a graph illustrating changes of ON current and OFF current depending on a reset voltage variation of a memory element according to at least one example embodiment;
FIG. 5. is a graph illustrating a change of ON/OFF current ratio depending on a reset voltage variation of a memory element according to at least one example embodiment;
FIG. 6 is a graph illustrating changes of ON current and OFF current based on the number of switching cycles per switching condition of a memory element according to at least one example embodiment;
FIG. 7 is a cross-sectional diagram illustrating a memory element according to a comparison example;
FIG. 8 is a graph illustrating changes of ON current and OFF current depending on a reset voltage variation of the memory element according to the comparison example of FIG. 7;
FIG. 9 is a graph illustrating a change of ON/OFF current ratio depending on a reset voltage variation of the memory element according to the comparison example of FIG.7;
FIG. 10 is a graph illustrating changes of ON current and OFF current based on the number of switching cycles per switching condition of the memory element according to the comparison example of FIG. 7;
FIGS. 11 and 12 are perspective diagrams each illustrating memory devices using memory elements according to at least one example embodiment;
FIG. 13 is a schematic diagram illustrating memory cards according to example embodiments; and
FIG. 14 is a block diagram illustrating electronic systems according to example embodiments.

It should be noted that these figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

### DETAILED DESCRIPTION

Example embodiments will now be described more fully with reference to the accompanying drawings, in which example embodiments are shown. Example embodiments may, however, be embodied in many different forms and should not be construed as being limited to the embodiments set forth herein; rather, these embodiments are provided so that this disclosure will be thorough and complete, and will fully convey the concept of example embodiments to those of ordinary skill in the art. In the drawings, the thicknesses of layers and regions are exaggerated for clarity. Like reference numerals in the drawings denote like elements, and thus their description will be omitted.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Like numbers indicate like elements throughout. As used herein the term "and/or" includes any and all combinations of one or more of the associated listed items. Other words used to describe the relationship between elements or layers should be interpreted in a like fashion (e.g., "between" versus "directly between," "adjacent" versus "directly adjacent," "on" versus "directly on").

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements and/or components, but do not preclude the presence or addition of one or more other features, integers, steps, operations, elements, components and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

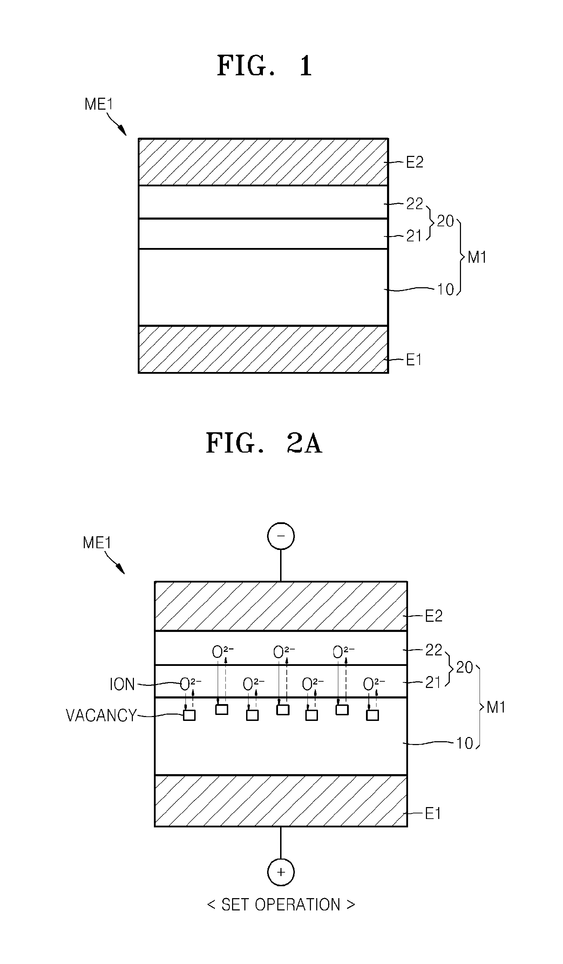

FIG. 1 is a cross-sectional diagram illustrating nonvolatile memory elements according to example embodiments. Referring to FIG. 1, a nonvolatile memory element (hereafter, referred to as a memory element) ME1 may include a memory layer M1 between first and second electrodes E1 and E2. The memory layer M1 may be a multi-layer structure. For example, the memory layer M1 may include a base layer 10 and an ionic species exchange layer 20. The memory layer M1 may be a resistance change memory layer with a resistance change characteristic caused by ionic species movement between the base layer 10 and the ionic species exchange layer 20.

The base layer 10 may include, for example, a metal oxide. For example, the base layer 10 may include at least one of tantalum (Ta) oxide, zirconium (Zr) oxide, yttrium (Y) oxide, yttria-stabilized zirconia (YSZ), titanium (Ti) oxide, hafnium (Hf) oxide, manganese (Mn) oxide, magnesium (Mg) oxide, and combinations thereof. If the metal oxide includes a Ta oxide, the Ta oxide may be TaOx where, 0<x<2.5 or 0.5≤x≤2.0. Oxygen ions and/or oxygen vacancies may exist in the base layer 10. This base layer 10 may function as an oxygen supplying layer (or oxygen reservoir layer) for the ionic species exchange layer 20. A thickness of the base layer 10 may be about 1 to about 100 nanometers (nm), for example, about 5 to about 50 nm.

The ionic species exchange layer 20 may send and receive (e.g., exchange) an ionic species to/from the base layer 10 and may induce a resistance change of the memory layer M1. The ionic species may be oxygen ions and/or oxygen vacancies. The ionic species exchange layer 20 may be referred to as an oxygen exchange layer. The ionic species exchange layer 20 may be a multi-layer structure including at least two layers. For example, the ionic species exchange layer 20 may be a bi-layer structure including first and second exchange layers 21 and 22 which include different materials. The first exchange layer 21 may be between the base layer 10 and the second electrode E2, and the second exchange layer 22 may be between the first exchange layer 21 and the second electrode E2. If the ionic species exchange layer 20 is an oxygen exchange layer, the first exchange layer 21 may be referred to as a first oxygen exchange layer and the second exchange layer 22 may be referred to as a second oxygen exchange layer.

Each of the first exchange layer 21 and second exchange layer 22 may exchange oxygen ions and/or oxygen vacancies with the base layer 10 and may induce resistance change of the memory layer M1. The second exchange layer 22 may send and receive oxygen ions and/or the oxygen vacancies to/from the base layer 10 and the first exchange layer 21, and may induce a resistance change of the memory layer M1. According to the characteristics of the first and second exchange layers 21 and 22, for example, according to the characteristics of the second exchange layer 22, the resistance change characteristics (for example, a width of the resistance change) and an operation condition of the memory layer M1 may be changed. By using the ionic species exchange layer 20 of the multi-layer structure, the width (e.g., range) of the resistance change of the memory layer M1 may become wider and it may be possible to use various resistance states (for example, four or more resistance states).

The memory layer M1 may be a multi-bit memory layer with a multi-bit memory characteristic. An operation voltage of the memory layer M1 may decrease and an effect of reducing power consumption may also be obtained. The memory element ME1 according to at least one example embodiment may obtain various effects by using the ionic species exchange layer 20 that may include a plurality of layers. The first and second exchange layers 21 and 22 may include different materials.

The first exchange layer 21 and the second exchange layer 22 may include, for example, different metal oxides (different kinds of metal oxides). If the first exchange layer 21 includes a first metal oxide, the second exchange layer 22 may include a second metal oxide which is different from the first metal oxide. The first metal oxide and the second metal oxide may be of different metal compositions. For example, the first exchange layer 21 may include one of Ta oxide, Zr oxide, Y oxide, YSZ, Ti oxide, Hf oxide, Mn oxide, Mg oxide, and combinations thereof. The second exchange layer 22 may include one of Ta oxide, Zr oxide, Y oxide, YSZ, Ti oxide, Hf oxide, Mn oxide, Mg oxide, and combinations thereof, but different from the material of the first exchange layer 21. The first metal oxide of the first exchange layer 21 and/or the second metal oxide of the second exchange layer 22 may be the same kind of oxide as a metal oxide constituting the base layer 10. Although the first and/or second metal oxide may be the same kind of oxide as the metal oxide of the base layer 10, composition ratios and properties of the metal oxide may be different.

Resistivity of the second exchange layer 22 that is closer to the second electrode E2 may be higher than that of the first exchange layer 21 that is closer to the base layer 10. If the memory layer M1 is in an OFF state, in the case where the resistivity of the second exchange layer 22 is higher than that of the first exchange layer 21, an OFF-current level of the memory layer M1 may be lowered by the second exchange layer 22. A conduction band offset between the second exchange layer 22 and the base layer 10 may be larger than between the first exchange layer 21 and the base layer 10. A potential barrier between the second exchange layer 22 and the base layer 10 may be higher than a potential barrier between the first exchange layer 21 and the base layer 10. An excessive current flow between the base layer 10 and the second electrode E2 may be suppressed by the second exchange layer 22.

An oxygen affinity of the second exchange layer 22 may be greater than or equal to that of the first exchange layer 21. In an operating process of the memory element ME1, oxygen ions may be moved from the base layer 10 to the first and second exchange layers 21 and 22. If the oxygen affinity of the second exchange layer 22 is low, the oxygen ions may be difficult to move to the second exchange layer 22. If the oxygen affinity of the second exchange layer 22 is equal to or greater than that of the first exchange layer 21, the second exchange layer 22 may function as an oxygen exchange layer (e.g., easily function).

The present explanation related to the oxygen affinity may be for the case where the first and second exchange layers 21 and 22 may be oxygen exchange layers. The ion exchange concept also applies to the case where ionic species exchanged by the first and second exchange layers 21 and 22 are not oxygen. In the case of using ionic species other than oxygen, the affinity of the second exchange layer 22 for a corresponding ionic species may be equal to or greater than that of the first exchange layer 21.

The metal oxide (the first metal oxide) of the first exchange layer 21 or the metal oxide (the second metal oxide) of the second exchange layer 22 may be the same kind of oxide as or a different kind of oxide from the metal oxide of the base layer 10. Although the first or second metal oxide may be the same kind of oxide as the metal oxide of the base layer 10, composition ratios and properties of the first and second metal oxides may be different. The first metal oxide and/or the second metal oxide may be a stoichiometric composition or a composition similar thereto. For example, in the case where the first metal oxide includes Ta oxide, the Ta oxide may be Ta₂O₅ or a composition similar thereto. In the case where the base layer 10 may include Ta oxide, a composition thereof may be expressed as TaOx, where 0<x<2.5 or 0.5≤x≤2.0. The oxygen concentration of the first metal oxide of the first exchange layer 21 may be higher than that of the base layer 10. Similarly, the oxygen concentration of the second metal oxide that may constitute the second exchange layer 22 also may be higher than that of the base layer 10.

According to at least one example embodiment, the oxygen concentration of the ionic species exchange layer 20 may not be greater than that of the base layer 10. In the case where the first exchange layer 21 and/or the second exchange layer 22 is the same kind of metal oxide as that of the base layer 10, the oxygen concentration of the first exchange layer 21 and/or the second exchange layer 22 may be higher than that of the base layer 10.

According to at least one other example embodiment, where the first exchange layer 21 or the second exchange layer 22 includes a different kind of metal oxide from that of the base layer 10, the oxygen concentration of the first exchange layer 21 or second exchange layer 22 may not be higher than that of the base layer 10. Oxygen mobility (or, oxygen diffusivity) of the first exchange layer 21 and/or the second exchange layer 22 may be substantially equal to or greater than that of the base layer 10. Resistivity of the first exchange layer 21 and/or the second exchange layer 22 may be greater than that of the base layer 10.

In the ON state in which a current path is formed in the ionic species exchange layer 20, the resistance of the memory layer M1 may be determined by the resistance of the base layer 10. In the OFF state in which the current path may not be formed in the ionic species exchange layer 20, the resistance of the memory layer M1 may be determined by the resistance of the ionic species exchange layer 20.

A thickness of the first exchange layer 21 may be about 1 to about 50 nm, for example, about 5 to about 20 nm. The first exchange layer 21 may be thinner than the base layer 10. A thickness of the second exchange layer 22 may be equal to that of the first exchange layer 21 or may be less than the first exchange layer 21. In the case where the second exchange layer 22 is thinner than the first exchange layer 21, the thickness of the second exchange layer 22 may be about 1 to about 30 nm, for example, about 1 to about 15 nm. Because the resistivity of the second exchange layer 22 may be higher than that of the first exchange layer 21, if the thickness of the second exchange layer 22 is excessive, the total resistance of the ionic species exchange layer 20 may increase to an unwanted level.

The first and second electrodes E1 and E2 may be a noble metal, for example, platinum (Pt), iridium (Ir), palladium (Pd), aurum (Au), or ruthenium (Ru) and/or an alloy thereof. The first and second electrodes E1 and E2 may be a non-noble metal, for example, titanium (Ti), tantalum (Ta), titanium nitride (TiN), titanium-tungsten (TiW), tantalum nitride (TaN), tungsten (W), nickel (Ni), or aluminum (AI) and/or a compound material thereof. The first and second electrodes E1 and E2 may be compound materials of a noble metal and a non-noble metal. The first and second electrodes E1 and E2 may be conductive oxides. The conductive oxide may be, for example, a zinc oxide (ZnO) based oxide (e.g., indium zinc oxide (IZO), a stannum (tin) oxide (SnO)) based oxide (e.g., indium tin oxide (ITO)), and/or may be other oxides, for example, a metal oxide (e.g., IrO₂). According to at least some example embodiments, it is possible to apply various electrode materials generally used in semiconductor devices as materials of the first and second electrodes E1 and E2.

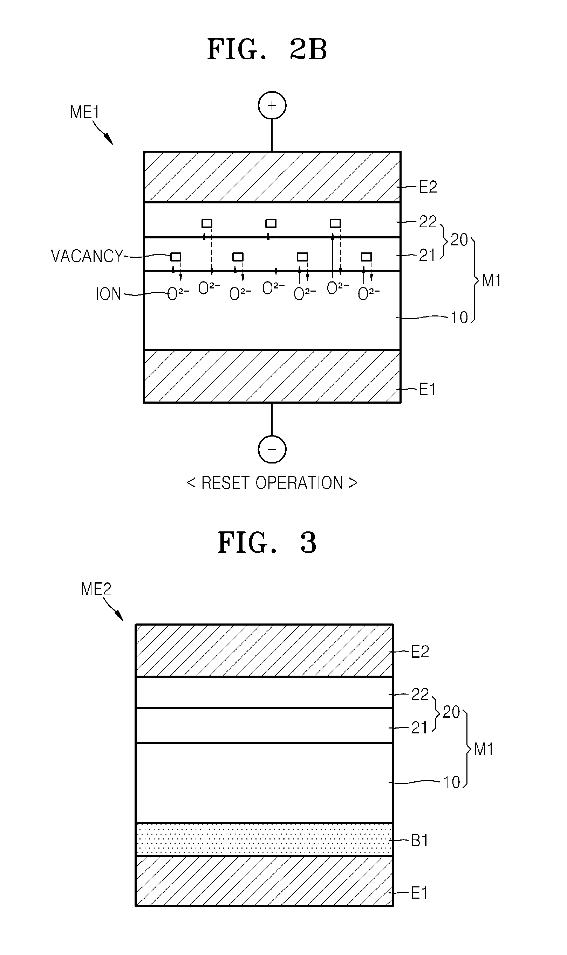

FIGS. 2A and 2B are cross-sectional diagrams illustrating operation mechanisms of a nonvolatile memory element according to at least one example embodiment. Referring to FIG. 2A, during a set operation in which a positive (+) voltage is applied to the first electrode E1 and a negative (-) voltage is applied to the second electrode E2, oxygen vacancies may move from the base layer 10 to the ionic species exchange layer 20, and a current path (not shown) may be formed in the ionic species exchange layer 20. The resistance of the memory layer M1 may decrease. The memory layer M1 may be changed from an OFF state to an ON state. In the set operation, the oxygen ions may move in an opposite direction to that of the oxygen vacancies, that is, from the ionic species exchange layer 20 to the base layer 10. The oxygen ions of the first exchange layer 21 may move to the base layer 10, and the oxygen ions of the second exchange layer 22 may move to the base layer 10. The oxygen ions of the second exchange layer 22 may move to the first exchange layer 21. At least a portion of the oxygen ions moved from the second exchange layer 22 to the first exchange layer 21 may be moved to the base layer 10.

Referring to FIG. 2B, during a reset operation in which a negative (-) voltage is applied to the first electrode E1 and a positive (+) voltage is applied to the second electrode E2, the oxygen vacancies may move from the ionic species exchange layer 20 to the base layer 10 and the oxygen ions may move from the base layer 10 to the ionic species exchange layer 20. The oxygen ions may move from the base layer 10 to the first exchange layer 21 and/or the second exchange layer 22. Oxygen ions of the first exchange layer 21 may move to the second exchange layer 22. When the oxygen ions and the oxygen vacancies move, the current path (not shown) formed in the ionic species exchange layer 20 may be cut off. The resistance of the memory layer M1 may increase. The memory layer M1 may be changed from the ON state to the OFF state.

As stated above, in connection with that the ionic species exchange layer 20 that may include a plurality of layers, for example, the first and second exchange layers 21 and 22, that may be of different materials, the resistance change characteristics and operation conditions of the memory layer M1 may be changed and improved. Due to a structure of the ionic species exchange layer 20, a resistance change width of the memory layer M1 may be wider, and consequently the memory layer M1 may be set to various resistance states (for example, four or more resistance states) depending on a condition of an operation voltage of the memory layer M1. The memory layer M1 may be a multi-bit memory with a multi-bit characteristic. Due to the structure of the ionic species exchange layer 20, the operation voltage of the memory layer M1 may decrease and an effect of reducing power consumption may be also obtained.

The memory element ME1 of FIG. 1 may be variously modified. For example, a buffer layer may be included between the first electrode E1 and the base layer 10.

FIG. 3 is a cross-sectional diagram illustrating memory elements according to other example embodiments. Referring to FIG. 3, a memory element ME2 according to at least one example embodiment may include a buffer layer B1 between the first electrode E1 and the base layer 10. The buffer layer B1 may improve reliability, reproducibility, and stability of the resistance change characteristics of the memory layer M1. The buffer layer B1 may include a material of which interatomic bonding energy is greater than that of the memory layer M1. The interatomic bonding energy in the buffer layer B1 may be greater than interatomic (e.g., Ta-O) bonding energy in the base layer 10. The buffer layer B1 may include a more stable material than that of the memory layer M1 in terms of bonding energy.

The buffer layer B1 may include a material for increasing the height of a potential barrier between the first electrode E1 and the memory layer M1. A conduction band offset between the buffer layer B1 and the first electrode E1 may be larger than that between the base layer 10 and the first electrode E1. The buffer layer B1 may include a material that suppresses excessive current flow between the first electrode E1 and the base layer 10. In order to produce a similar effect, the buffer layer B1 may include a material of which resistivity is higher than that of the memory layer M1. The buffer layer B1 may include at least one of AlOx, SiOx, SiNx, ZrOx, HfOx, and combinations thereof. The buffer layer B1 may or may not have a stoichiometric composition. The buffer layer B1 may have suitable composition and thickness to function as a buffer and to allow flow of electric current. The thickness of the buffer layer B1 may be less than or equal to about 10 nm, for example. If the buffer layer B1 is a stoichiometric composition, the thickness of the buffer layer B1 may be less than or equal to about 5 nm. If the buffer layer B1 has an excessive thickness, insulation properties of the buffer layer B1 may undesirably increase. A thickness of the buffer layer B1 may be less than or equal to about 10 nm.

The buffer layer B1 may improve stability, reliability, and reproducibility of the resistance change characteristics during the set and reset operations. In the case of forming the first electrode E1 with high reactivity material (for example, a non-noble metal) without the buffer layer B1, the oxygen ions and/or the oxygen vacancies, which may be involved in the resistance change during the set or reset operation, may move to the first electrode E1 and then may cause a physical/chemical reaction with the first electrode E1, or the memory layer M1 itself and the first electrode E1 may cause a physical/chemical reaction with each other. This may cause trouble for stability, reliability, and reproducibility of the resistance change characteristics.

According to repetition of the ON/OFF operation, a possibility in which a reaction of the first electrode E1 may occur may be increased. According to at least one example embodiment, if the buffer layer B1 is between the first electrode E1 and the memory layer M1, it may be possible to suppress/prevent the above problem and improve/secure stability, reliability, and reproducibility of the resistance change characteristics. During an initial set operation (that is, forming operation), the buffer layer B1 may reduce/prevent a chemical reaction between the first electrode E1 and the base layer 10 and between the first electrode E1 and the ionic species of the base layer 10. The buffer layer B1 may also reduce/prevent the base layer 10 from reacting with the first electrode E1, when forming the base layer 10.

In the case of using the buffer layer B1, it may be possible to easily apply low cost non-noble metal or conductive oxide as a material of the first electrode E1. In the case of forming the first electrode E1 with the low cost non-noble metal or conductive oxide, manufacturing cost decreases and it may be possible to obtain various benefits to manufacturing processes. According to example embodiments, forming the buffer layer B1 is optional. Depending on material of the first electrode E1 and/or the base layer 10, the buffer layer B1 may not be necessary.

The second exchange layer 22 of the ionic species exchange layer 20 may affect the memory characteristics of a nonvolatile memory element and may take a role somewhat similar to that of the buffer layer B1. The second exchange layer 22 may prevent an excessive current flow between the memory layer M1 and the second electrode E2 and an unwanted physical/chemical reaction between the memory layer M1 and the second electrode E2. A function (e.g., a main function) of the second exchange layer 22 may be to exhibit memory characteristics according to an ionic species exchange with the first exchange layer 21 and the base layer 10. Functioning as a buffer layer may be an additional function of the second exchange layer 22. Depending on the material of the second electrode E2, the second exchange layer 22 may not function as the buffer layer.

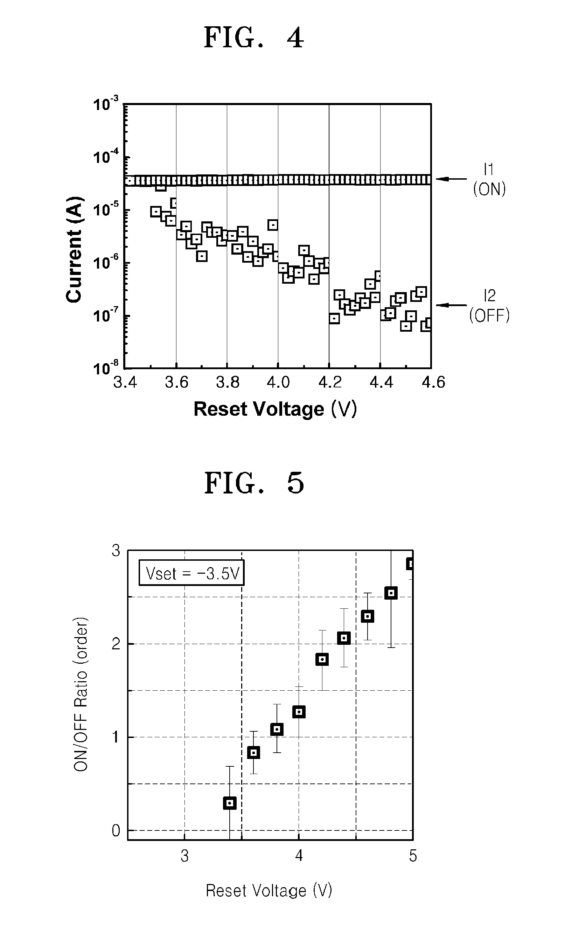

FIG. 4 is a graph illustrating changes of ON current and OFF current depending on a reset voltage variation of a memory element according to at least one example embodiment. The memory element used to obtain the result of FIG. 4 may be a W/Al₂O₃/TaOx/Ta₂O₅/HfO₂/Pt structure. A structure of the memory element may be the structure of FIG. 3, and may use W, Al₂O₃, TaOx, Ta₂O₅, HfO₂, and Pt as materials of the first electrode E1, the buffer layer B1, the base layer 10, the first exchange layer 21, the second exchange layer 22, and the second electrode E2, respectively. Changes of the ON current and OFF current may be measured while increasing the reset voltage from 3.4 volts to 4.6 volts. A set voltage may be - 3.5 volts. The current I1 illustrates a level of the ON current, and I2 illustrates a level of the OFF current.

Referring to FIG. 4, the OFF current level I2 may be changed relatively with a wide width depending on the reset voltage variation. It may be understood that various OFF current levels are generated depending on a level of the reset voltage. As the reset voltage increases, the OFF current level I2 may decrease. From this result, it may be understood that the memory element according to at least one example embodiment may exhibit various resistance states depending on operation voltage conditions (in particular, reset voltage conditions). A memory element according to example embodiments may be a multi-bit memory with multi-bit memory characteristics.

FIG. 5. is a graph illustrating a change of ON/OFF current ratio depending on a reset voltage variation of a memory element according to at least one example embodiment. Referring to FIG. 5, an ON/OFF current ratio may increase by 2 orders of magnitude (e.g., 100 times or more) as the reset voltage increases from about 3.4 volts to about 5.0 volts. This may be because the OFF current level of the memory element decreases as the reset voltage increases. Using a plurality of voltage levels between 3.4 volts and 5.0 volts as reset voltages may result in a plurality of different resistance states, and the plurality of different resistance states may correspond to a plurality of data (information). Because a change width of the ON/OFF current ratio that depends on the reset voltage variation may be large, a large number of resistance states may be clearly differentiated from each other within an operation voltage range may. A memory element according to example embodiments may be a multi-bit memory with multi-bit memory characteristics.

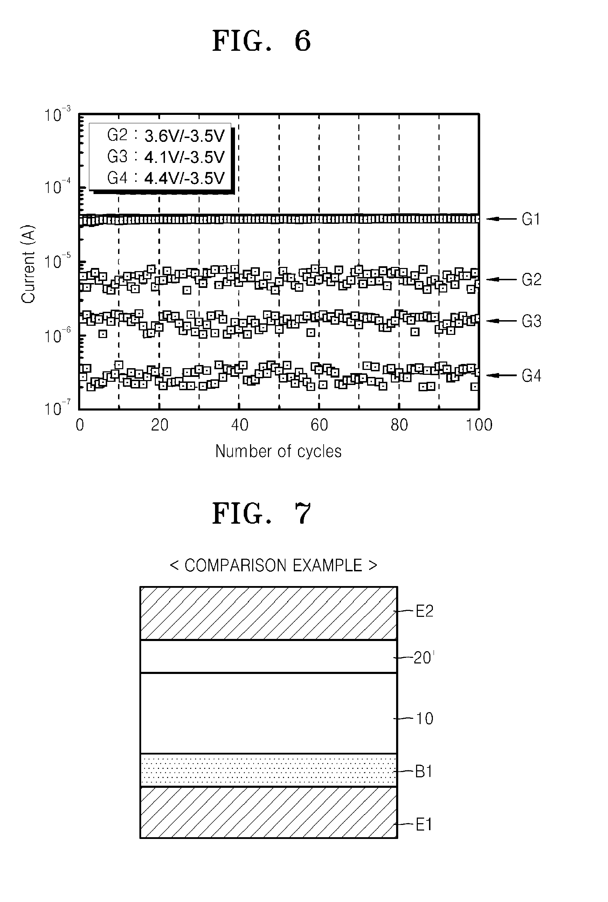

FIG. 6 is a graph illustrating changes of ON current and OFF current depending on the number of switches per switching condition of a memory element according to at least one example embodiment. The memory element that may correspond to the result of FIG. 6 may be a W/Al₂O₃/TaOx/Ta₂O₅/HfO₂/Pt structure. For this memory element, the changes of ON current and OFF current may be measured while repeating a switching operation by using the reset voltages of 3.6 volts, 4.1 volts, and 4.4 volts. The set voltage may be -3.5 volts. A first graph G1 may indicate an ON current, a second graph G2 may illustrate an OFF current in the case where the reset voltage is 3.6 volts, a third graph G3 may illustrate an OFF current in the case where the reset voltage is 4.1 volts, and a fourth graph G4 may illustrate an OFF current in the case where the reset voltage is 4.4 volts.

Referring to FIG. 6, current levels of the four graphs G1-G4 may be clearly distinguished from each other without an overlap (e.g., a sufficient read margin). The first graph G1 may correspond to data "00", the second graph G2 may correspond to data "01", the third graph G3 may correspond to data "10", and the fourth graph G4 may correspond to data "11". According to example embodiments, a multi-bit memory characteristic may be stably maintained although the switching operation, (e.g., the ON/OFF operation) is repeated. A multi-bit characteristic of a multi-bit memory element according to example embodiments may be continuously maintained (cycling endurance).

FIG. 7 is a cross-sectional diagram illustrating a memory element according to a comparison example. Referring to FIG. 7, an ionic species exchange layer 20' may be a single layer structure. The ionic species exchange layer 20' may be the same material layer as the first exchange layer 21 of FIG. 3. Except that the ionic species exchange layer 20' is a single layer structure, a structure of the memory element of FIG. 7 may be the same as that of the memory element of FIG. 3. In the case where the ionic species exchange layer 20' is a single layer structure, a width of a resistance change may be limited, and it may be difficult to set various resistance states. An operation voltage (for example, the reset voltage) may be higher and power consumption may be increased.

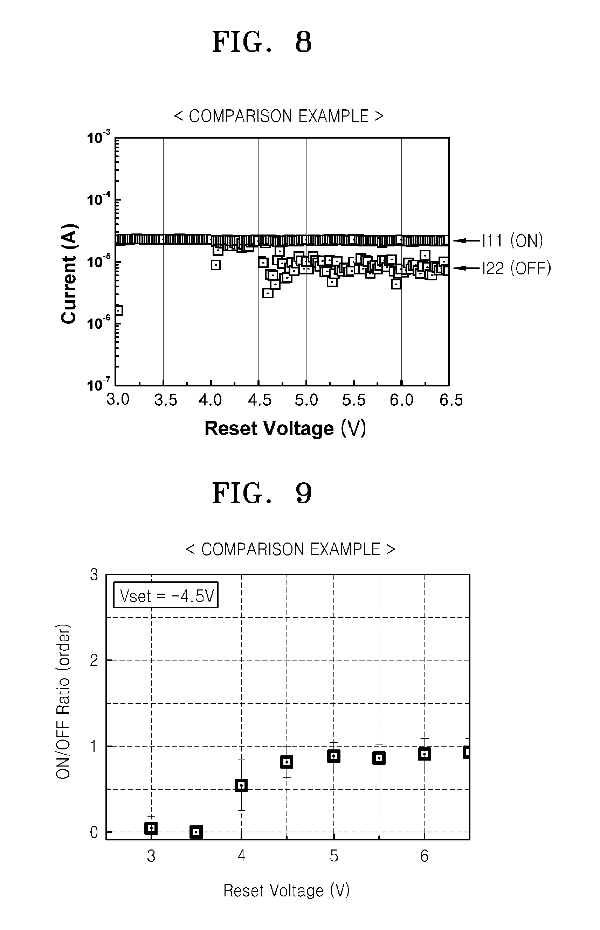

FIG. 8 is a graph illustrating changes of ON current and OFF current depending on a reset voltage variation of the memory element according to the comparison example of FIG. 7. A structure of the memory element used to obtain a result of FIG. 8 may be a W/Al₂O₃/TaOx/Ta₂O₅/Pt structure. The memory element according to the comparison example may be similar to the memory element according to the example embodiment of FIG. 4, but with a single layer structure of a Ta2O5 ionic species exchange layer (e.g., without a second exchange layer HfO₂). Changes of the ON current and OFF current may be measured while increasing the reset voltage from 3.0 volts to 6.5 volts. A set voltage may be -4.5 volts. A current I11 may illustrate a level of the ON current, and a current I22 may illustrate a level of the OFF current.

As shown in FIG. 8, the OFF current level I22 may not appear although the reset voltage increases to about 4.0 volts. The OFF current level I22 may appear when the reset voltage is over about 4.5 volts, but may not change while the reset voltage increases from 4.5 volts to 6.5 volts. It may be understood that, in the case of the memory element according to the comparison example of FIG. 7, a resistance change dependence on the reset voltage may be low. Because a change of the OFF current level I22 based on the reset voltage may be small, it may be difficult to realize multi-bit memory characteristics, for example, four or more resistance states.

The appearance of the OFF current level I22 in the reset voltage over about 4.5 volts may mean that an operation voltage of the memory element according to the comparison example is over about 4.5 volts. In the memory element according to example embodiments, as shown in FIG. 4, the OFF current level I2 may appear in a low reset voltage of about 3.5 volts. An operation voltage of the memory element according to example embodiments may be lower than that of the memory element according to the comparison example. A memory element according to example embodiments may reduce power consumption as compared to the memory element according to the comparison example.

FIG. 9 is a graph illustrating a change of ON/OFF current ratio depending on a reset voltage variation of the memory element according to the comparison example of FIG. 7. Referring to FIG. 9, an ON/OFF current ratio (the current ratio of the ON current to the OFF current) may be almost "0" for a reset voltage under about 4.0 volts, and may be maintained within about "1" order of magnitude in the reset voltage over 4.5 volts. This means that the ON/OFF current ratio may not be increased over "1" order of magnitude (e.g., 10 times) although the reset voltage is increased.

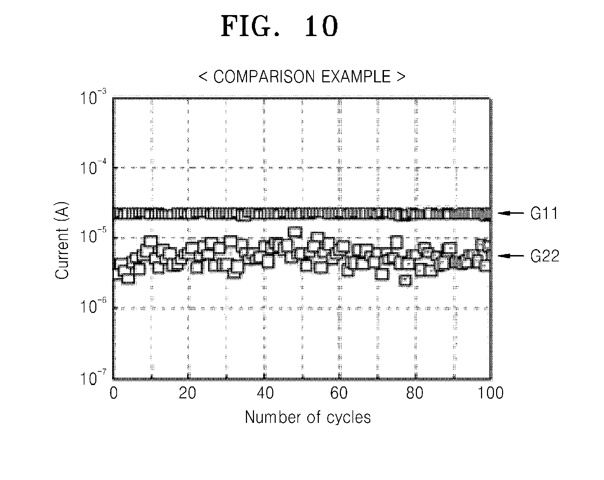

FIG. 10 is a graph illustrating changes of ON current and OFF current depending on the number of switches per switching condition of the memory element according to the comparison example of FIG. 7. For the memory element according to the comparison example, the changes of the ON current and OFF current may be measured while repeating a switching operation by using reset voltages of 5.5 volts and the set voltage of -4.5 volts. A first graph G11 may indicate the ON current and a second graph G22 may illustrate the OFF current.

Referring to FIG. 10, in the case of the memory element according to the comparison example (a memory element that may use a single layer ionic species exchange layer) only two resistance states may be illustrated and it may be difficult to make three or more resistance states. The memory element according to the comparison example may have a single bit memory characteristic and it may be difficult to provide a multi-bit memory characteristic to the memory element according to the comparison example.

It may be understood that a memory element according to example embodiments may be a multi-bit memory with a multi-bit memory characteristic. A memory element according to example embodiments may include an ionic species exchange layer with a multi-layer structure. The multi-bit characteristic may be continuously maintained (e.g., cycling endurance may be exhibited). It may be understood that the memory element according to example embodiments may be operated at a relatively low or reduced voltage compared to the memory element according to the comparison example.

A memory element according to example embodiments may be applied to memory devices of various structures. The memory devices may include a switching element connected to the memory element.

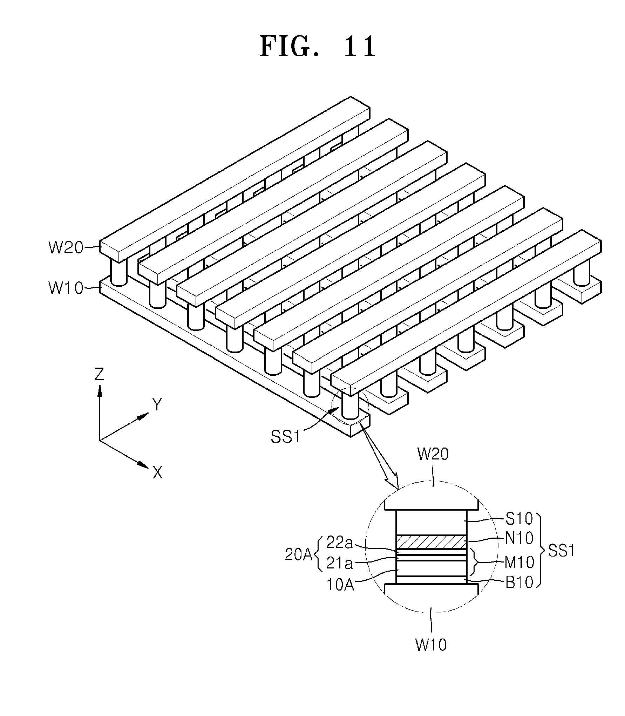

FIG. 11 is a perspective diagram illustrating an example of a memory device using a memory element according to example embodiments. The memory device according to example embodiments may be a cross-point resistive memory device. Referring to FIG. 11, the memory device may include a plurality of first wires W10 in parallel with each other in a first direction, for example, an X axis direction. The memory device may include a plurality of second wires W20 in a second direction crossing the first wires W10, for example, a Y axis direction. The memory device may include a plurality of first stacked structures (first memory cells) SS1. Each of the stacked structures SS1 may be at a point where a first wire W10 and a second wire W20 cross each other. The first stacked structure SS1 may include a first buffer layer B10, a first memory layer M10, a first intermediate electrode N10, and a first switching element S10, which are sequentially stacked on the first wire W10.

The first memory layer M10 may include a base layer 10A and an ionic species exchange layer 20A. The ionic species exchange layer 20A may be a multi-layer structure including two layers or more. For example, the ionic species exchange layer 20A may include a first exchange layer 21 a and a second exchange layer 22a. In the first stacked structure SS1, a position of a lower part structure (e.g., B10+M10) and a position of an upper part structure (i.e., S10) may be switched with each other based on the first intermediate electrode N10. The first buffer layer B10 and the first memory layer M10 may correspond to the buffer layer B1 and the memory layer M1 of FIG. 3, respectively. The first switching element S10 may be a two-way diode, a threshold switching device, a varistor, and/or the like.

If the first switching element S10 is a two-way diode, the two-way diode may be an oxide diode, for example. In the case of a silicon diode, because the silicon diode may be formed in a high temperature process of about 800°C, there may a limitation in selecting a substrate and various problems may occur due to the high temperature. A first switching element S10 with an oxide layer may be easily formed at room temperature. Example embodiments may not exclude silicon as a material of the first switching element S10. In some cases, the first switching element S10 may be silicon or various other materials. The first wire W10 and the first intermediate electrode N10 may correspond to the first electrode E1 and the second electrode E2 of FIG. 1, respectively. The second wire W20 may be formed of the same material as the first wire W10. The second wire W20 may be of a different material from the first wire W10. According to at least one example embodiment, the first buffer layer B10 may not be formed.

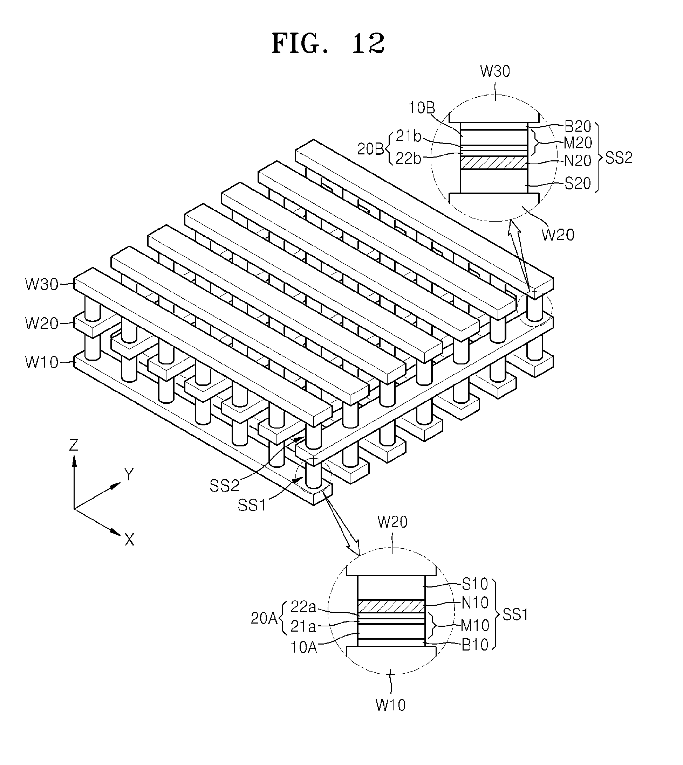

A second memory cell and a third wire may be on the second wire W20 of FIG. 11. FIG. 12 is a perspective diagram illustrating an example of a memory device using a memory element according to example embodiments. Referring to FIG. 12, the first wires W10, the second wires W20, and the first stacked structures (the first memory cells) SS1 between the first and second wires W10 and W20, which are described with reference to FIG. 11, may be provided. Third wires W30 may be apart from upper surfaces of the second wires W20 by an interval. The third wires W30 may cross the second wires W20 and may be arranged apart from each other by the same interval. A plurality of second stacked structures (second memory cells) SS2 may be at cross-points where the second wires W20 and the third wires W30 cross each other.

The second stacked structure SS2 may be a reverse structure of the first stacked structure SS1 or the same structure as that of the first stacked structure SS1. The case where the second stacked structure SS2 is a reverse structure of the first stacked structure SS1 may be illustrated. The second stacked structure SS2 may include a second switching element S20, a second intermediate electrode N20, a second memory layer M20, and a second buffer layer B20, which may be sequentially stacked on the second wire W20. The second memory layer M20 may include an ionic species exchange layer 20B and a base layer 10B. The ionic species exchange layer 20B may be a multi-layer structure including two or more. For example, the ionic species exchange layer 20B may include a first exchange layer 21 b and a second exchange layer 22b.

The ionic species exchange layer 20B and the base layer 10B may be the same material layers as the ionic species exchange layer 20A and the base layer 10A of the first stacked structure SS1, respectively. The second switching element S20 may be a reverse structure of the first switching element S10. According to some example embodiments, the second switching element may be the same stacked structure as that of the first switching element S10. A switching direction of the second switching element S20 may be opposite to or the same as that of the first switching element S10. The second buffer layer B20 may be the same material as the first buffer layer B10. According to some example embodiments, the second buffer layer B20 may not be included. In the second stacked structure SS2, a position of a lower part structure (e.g., S20) and a position of an upper part structure (e.g., M20+B20) may be switched with each other based on the second intermediate electrode N20. The third wire W30 and the second intermediate electrode N20 may correspond to the first electrode E1 and the second electrode E2 of FIG. 1, respectively, or may correspond to the second electrode E2 and the first electrode E1, respectively.

In FIGS. 11 and 12, although the first and second stacked structures SS1 and SS2 may be illustrated in a cylindrical shape, a shape of the first and second stacked structures SS1 and SS2 may be variously modified. For example, the first and second stacked structures SS1 and SS2 may be a square pillar shape and/or a shape in which width increases downward. For example, a shape of the first and second stacked structures SS1 and SS2 may be asymmetric and the first and second stacked structures SS1 and SS2 may extend to the outside of the cross-points of the first and second wires W10 and W20, and the outside of the cross-points of the second and third wires W20 and W30. As will be understood by one of ordinary skill with knowledge of example embodiments, the structures of FIGS. 11 and 12 may be variously modified.

Although not shown, according to some example embodiments, the resistive memory device shown in FIG. 12 may include a stacked structure that may be the same as the stacked structure including the first stacked structures SS1 and the second wires W20, on the third wires W30 (and so on). According to some example embodiments, a resistive memory device according to example embodiments may include at least one set of a stacked structure that may be the same as the stacked structure including the first stacked structures SS1, the second wires W20, the second stacked structures SS2, and the third wires W30, on the third wires W30. According to some example embodiments, a resistive memory device may include at least one set of a stacked structure that may be the same as the stacked structure including the first stacked structures SS1, the second wires W20, the second stacked structures SS2, the third wires W30, the first stacked structures SS1, and the second wires W20, which may be sequentially stacked, on the third wires W30.

In the memory device of FIGS. 11 and 12, the first memory layer M10 may have excellent and/or improved memory and operation characteristics by, for example, using a multi-layer ionic species exchange layer 20A. Due to the ionic species exchange layer 20A, the first memory layer M10 may be a multi-bit memory with multi-bit memory characteristics and may be operated at a low and/or decreased voltage. Similarly, due to the ionic species exchange layer 20B, the second memory layer M20 of FIG. 12 may be a multi-bit memory with multi-bit memory characteristics and may be operated at a low voltage. A high and/or improved density memory device may be achieved. In a case of a scale down method of reducing a line width of a memory device, there may be many difficulties in raising an integration density of the memory device due to process limitations. However, if storing multi-bit data in a single memory cell (e.g., according to example embodiments), it may be possible to increase an information storage amount per unit area (e.g., two times or more compared to a single bit memory). A memory device according to example embodiments may be a high and/or improved integration density device.

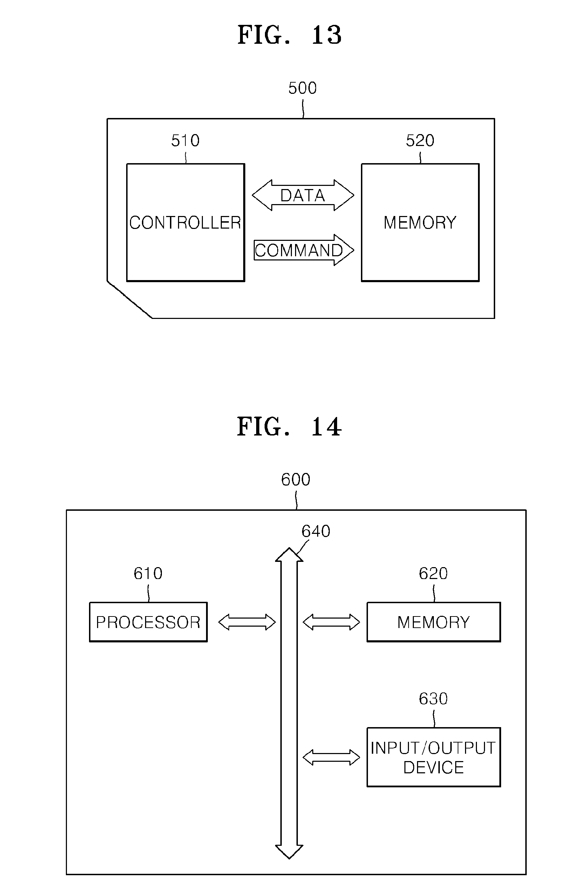

FIG. 13 is a schematic diagram illustrating memory cards according to example embodiments. Referring to FIG. 13, a controller 510 and a memory 520 may exchange electric signals. For example, according to commands of the controller 510, the memory 520 and the controller 510 may exchange data. The memory card 500 may store data in the memory 520 and/or output data from the memory 520. The memory 520 may include one of the non-volatile memory devices described above in reference to FIGS. 1-12. A memory card 500 may be used as a storage medium for various portable electronic devices. For example, the memory card 500 may be a multimedia card (MMC) and/or a secure digital (SD) card.

FIG. 14 is a block diagram illustrating electronic systems according to example embodiments. Referring to FIG. 14, a processor 610, an input/output device 630, and a memory 620 may perform data communication with each other by using a bus 640. The processor 610 may execute a program and control the electronic system 600. The input/output device 630 may be used to input/output data to/from the electronic system 600. The electronic system 600 may be connected to an external device, for example, a personal computer and/or a network, by using the input/output device 630 and may exchange data with the external device.

The memory 620 may store code or programs for operations of the processor 610. For example, the memory 620 may include one of the non-volatile memory devices described above in reference to FIGS. 1-12. For example, an electronic system 600 may embody various electronic control systems requiring the memory 620, and, for example, may be used in mobile phones, MP3 players, navigation devices, solid state disks (SSD), and/or household appliances.

While example embodiments have been particularly shown and described, it will be understood by one of ordinary skill in the art that variations in form and detail may be made therein without departing from the scope of the claims.

## Claims

1. A nonvolatile memory element, comprising:
a first electrode;
a second electrode; and
a resistance change memory layer between the first and second electrodes, the memory layer including,
a base layer, and
an ionic species exchange layer including at least two layers.

2. The nonvolatile memory element of claim 1, wherein
the base layer is an oxygen supplying layer, and
the ionic species exchange layer is an oxygen exchange layer.

3. The nonvolatile memory element of claim 1 or 2, wherein a memory characteristic of the nonvolatile memory element is a multi-bit memory characteristic.

4. The nonvolatile memory element of claim 1, 2 or 3 wherein the at least two layers include,
a first exchange layer between the base layer and the second electrode, and
a second exchange layer between the first exchange layer and the second electrode,
and optionally wherein a thickness of the second exchange layer is less than or equal to a thickness of the first exchange layer.

5. The nonvolatile memory element of claim 4, wherein a resistivity of the second exchange layer is greater than a resistivity of the first exchange layer.

6. The nonvolatile memory element of claim 4 or 5, wherein an oxygen affinity of the second exchange layer is greater than or equal to an oxygen affinity of the first exchange layer.

7. The nonvolatile memory element of claim 4, 5 or 6, wherein a conduction band offset of the second exchange layer to the base layer is greater than a conduction band offset of the first exchange layer to the base layer.

8. The nonvolatile memory element of any of claims 4 to 7, wherein the first exchange layer and the second exchange layer are different metal oxides,
and optionally wherein the first exchange layer includes at least one of tantalum (Ta) oxide, zirconium (Zr) oxide, yttrium (Y) oxide, yttria-stabilized zirconia (YSZ), titanium (Ti) oxide, hafnium (Hf) oxide, manganese (Mn) oxide, magnesium (Mg) oxide, and combinations thereof,
and further optionally wherein the second exchange layer includes at least one of Ta oxide, Zr oxide, Y oxide, YSZ, Ti oxide, Hf oxide, Mn oxide, Mg oxide, and combinations thereof.

9. The nonvolatile memory element of any of claims 1 to 8, wherein the base layer includes a metal oxide;
and optionally wherein an oxygen concentration of the base layer is lower than an oxygen concentration of the ionic species exchange layer;
and further optionally wherein the metal oxide of the base layer includes at least one of Ta oxide, Zr oxide, Y oxide, YSZ, Ti oxide, Hf oxide, Mn oxide, Mg oxide, and combinations thereof.

10. The nonvolatile memory element of claim 9, wherein
the metal oxide of the base layer includes TaOx, and 0<x<2.5.

11. The nonvolatile memory element of any of claims 1 to 10, further comprising:
a buffer layer between the first electrode and the memory layer,
and optionally wherein the buffer layer includes a material configured to increase a height of a potential barrier between the first electrode and the memory layer.

12. A memory device, comprising:
the nonvolatile memory element according to any of claims 1 to 11; and
a switching element connected to the nonvolatile memory element.

13. A memory device, comprising:
a plurality of first wires;
a plurality of second wires crossing the first wires; and
a plurality of first memory cells at a plurality of first cross-points between the first and second wires, each of the first memory cells including the nonvolatile memory element according to any of claims 1 to 11, the nonvolatile memory element including the resistance change memory layer, the resistance change memory layer including the base layer and the ionic species exchange layer, the ionic species exchange layer including the at least two layers.

14. The memory device of claim 13, wherein each of the first memory cells include,
a switching element between the memory layer and the second wire, and
an intermediate electrode between the memory layer and the switching element.

15. The memory device of claim 13 or 14, further comprising:
a plurality of third wires crossing the second wires; and
a plurality of second memory cells at a plurality of second cross-points between the second and third wires;
and optionally wherein the second memory cells are one of a reverse structure of the first memory cell and a same structure as the first memory cell.
